# EUROPEAN PATENT APPLICATION

(11) **EP 1 736 517 A1**
(43) Date of publication of application: **27.12.2006**
(21) Application number: 06012687.7
(22) Date of filing: 20.06.2006
(51) Int. Cl.: C09J 9/00, C09J 9/02, C08K 3/00, C08K 5/00, C08K 5/56, H01L 21/00, H01L 21/60

(54) **Metal salts of maleimide compounds as conductivity promoters**

(30) Priority: 21.06.2005 US 157611
(71) Applicant: National Starch and Chemical Investment Holding Corporation, New Castle, Delaware 19720 (US)
(72) Inventor: Musa, Osama M., Hillsborough New Jersey 08844 (US)
(74) Representative: Held, Stephan

(57) **Abstract**

A conductive resin composition comprises a resin, a conductive filler, and the metal salt of a compound containing maleimide functionality.

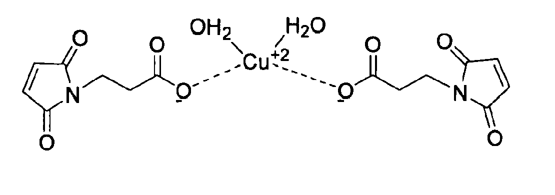

## Description

### FIELD OF THE INVENTION

This invention relates to conductive resin compositions and in particular to conductive resin compositions containing metal salts of maleimide compounds.

### BACKGROUND OF THE INVENTION

Conductive fillers are added to resin compositions in order to make them either thermally or electrically conductive. Conductive resins compositions have a wide variety of uses, such as, replacement for solder, for example, in attaching a circuit component to a circuit board or a semiconductor die to a leadframe; shielding, for example, as a conductive coating to carry away stray current or static electricity; conductive ink, for example, as a polymer thick film ink or an RFID ink for a conductive antenna; tantalum capacitor; or thermal interface material, for example, as a silicon gel or grease for heat dissipation.

In particular, conductive resins can be used as adhesives for attaching semiconductor dies or chips to a substrate. For some uses, those that require a high level of electrical conductivity between the die and the substrate, for example in a power integrated circuit or as a replacement for solder, enhanced conductivity is necessary. The obvious method for doing this is to increase the loading of the conductive filler in the resin composition or to utilize a more conductive filler. Either of these methods, however, may affect the rheology or other performance characteristics of the composition.

### SUMMARY OF THE INVENTION

The inventor has discovered that the addition of a metal salt of a compound containing both carboxylic acid functionality and maleimide functionality (hereinafter "metal salt of a maleimide acid") to a conductive resin composition comprising a resin and a conductive filler, improves the conductivity of the composition, particularly its electrical conductivity, without detriment to worklife or rheology. The improved conductive resin composition is thus commercially suitable for applications within the semiconductor packaging industry, and especially for applications that require a high level of electrical conductivity.

### DETAILED DESCRIPTION OF THE INVENTION

This invention is a conductive resin composition comprising a resin, a conductive filler, and a metal salt of a maleimide. As used within this specification and claims, the metal salt of a maleimide acid shall mean the compound that is obtained by the conversion of an organic acid containing a maleimide moiety to the metal salt of that acid. The addition of the metal salt to the composition improves conductivity significantly. In this embodiment, the metal salt is activated by heat generated from the operation of the device in which the conductive resin composition is utilized.

In another embodiment the composition comprises a curable resin and a curing agent for the resin, a conductive filler, and a metal salt of a maleimide acid. This technology can be used in chemistries that cure via condensation, addition, and electron donor/electron acceptor reactions. In this embodiment, the metal salt of a maleimide acid is activated by the heat of reaction or by the input of heat to initiate the reaction.

The inventive metal salt of a maleimide acid is prepared by (i) reacting a molar equivalent of maleic anhydride with a molar equivalent of an amino acid to form an amic acid, (ii) dehydrating the amic acid to form a maleimide acid (as earlier defined), and (iii) converting the maleimide acid to the metal salt.

Suitable amino acids can be aliphatic or aromatic, and include, but are not limited to, glycine, alanine, 2-aminoisobutyric acid, valine, tert-leucine, norvaline, 2-amino-4-pentenoic acid, isoleucine, leucine, norleucine, beta-alanine, 5-aminovaleric acid, 6-aminocaproic acid, 7-aminoheptanoic acid, 8-aminocaprylic acid, 11-amino-undecanoic acid, 12-aminododecanoic acid, 2-phenylglycine, 2,2'-diphenylglycine, phenylalanine, alpha-methyl-DL-phenylalanine, and homophenylalanine.

The maleic anhydride is dissolved in an organic solvent, such as acetonitrile, and this solution added to a one mole equivalent of the amino acid. The mixture is allowed to react, typically for about three hours, at room temperature, until white crystals are formed. The white crystals are filtered off, washed with cold organic solvent (acetonitrile) and dried to produce the amic acid adduct. The amic acid adduct is mixed with base, typically triethylamine, in a solvent, such as toluene. The mixture is heated to 130°C for two hours to dehydrate the amic acid and form the maleimide ring. The organic solvent is evaporated and sufficient 2M HCL added to reach pH 2. The product is then extracted with ethyl acetate and dried, for example, over MgSO₄, followed by evaporation of the solvent.

The product from the above reaction is a compound containing both maleimide and carboxylic acid functionalities (hereinafter referred to as a "maleimide acid"). It will be understood by those skilled in the art that the hydrocarbon (aliphatic or aromatic) moiety separating the maleimide and acid functionalities is the derivative of the starting amino acid used to make the compound.

The conversion of the maleimide acid to a metal salt is known art, and is accomplished by the methods disclosed in the examples. In general, the conversion of the carboxylic acid functionality is conducted by combining the maleimide acid with a metal nitrate or halide.

The maleimide acid is mixed with water at 10°C or lower and sufficient base, for example, NH40H (assay 28-30 %), is added to raise the pH to about 7.0. A solution of a stoichiometric amount of metal nitrate or halide is prepared and is added to the reaction slurry over a short time (for example, five minutes) while maintaining the reaction temperature at or below 10°C. The reaction is held at that temperature and mixed for several hours, typically two to three hours, after which the mixture is allowed to return to room temperature and mixed for an additional 12 hours at room temperature.

The precipitate product, the metal salt of a maleimide, is filtered and washed with water (three times) and then with acetone (three times), and dried in a vacuum oven for 48 hours at about 45°C.

The metal elements suitable for coordination with the acid functionality of the maleimide acid are selected from the group consisting of lithium (Li), sodium (Na), magnesium (Mg), potassium (K), calcium (Ca), scandium (Sc), titanium (Ti), vanadium (V), chromium (Cr), manganese (Mn), iron (Fe), cobalt (Co), nickel (Ni), copper (Cu), zinc (Zn), palladium (Pd), platinum (Pt), silver (Ag), gold (Au), mercury (Hg), aluminum (Al), and tin (Sn). The nitrate or halide salts of these metals are the preferred salts for reaction with the maleimide acid.

The metal salts of maleimide are generally solid materials that can be milled into a fine powder for incorporating into the chosen resin composition. The metal salt will be present in the resin composition at a loading of 0.05% to 10% by weight of the composition. In one embodiment, the loading is around 0.1 % to 0.5% by weight.

Exemplary resins suitable for use in these compositions include phenolics, epoxies, acrylates, maleimides, polyimides, polyurethanes, vinyl chlorides, vinyl acetates, polyesters, silicones, benzoxazines, oxetane, thio-ene, oxazolines, nitrones, vinyl ethers, styrenics, and cinnamics. The particular choice of resin is not critical to the invention and the practitioner may choose the resin for curing and adhesive performance as suits the end use application. Such performance characteristics for the resins will be known to those skilled in the art.

The resin composition will also contain a conductive filler. Within this specification and the claims, the words "conductive filler" will be deemed to include (a) a metal in particle, flake, or powder form, and any combination of those, and (b) a nonconductive filler in particle, flake, or powder form, and any combination of those, onto which is coated a metallic surface. The size and shape of the particle, flake and powder are not critical to the invention. In general a combination of flake and powder is used in order to optimize the packing density of the filler. Typically, the conductive filler will be present in an amount from 20% to 95% by weight. In one embodiment, the filler is a silver filler, and is present in an amount from 70% to 90% by weight.

Suitable conductive fillers are metallic and include gold, silver, copper, cobalt, silver coated graphite, copper alloys, platinum, palladium, nickel, aluminum, silver coated copper, silver alloys with platinum or palladium, bronze or brass alloys. The choice of filler composition within the parameters disclosed in this specification for a specific end use application is within the expertise of one skilled in the art and is not critical to obtaining improved conductivity.

### EXAMPLES

EXAMPLE 1. PREPARATION OF MALEIMIDOCAPROIC ACID (2.1 MOL)/COPPER (II) NITRATE HEMIPENTAHYDRATE (1.0 MOL)

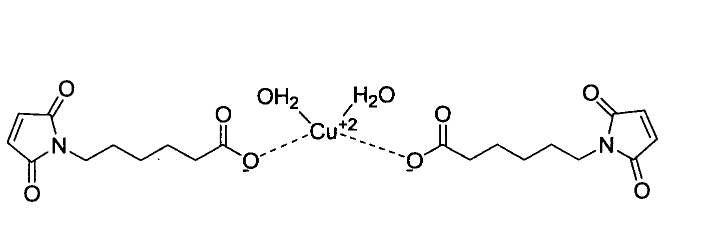

The starting material, maleimidocaproic acid 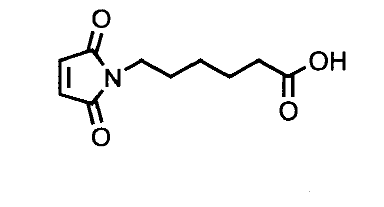 was prepared as follows: a solution of one mole equivalent of maleic anhydride in acetonitrile was added to a one mole equivalent of 6-aminocaprioc acid in acetic acid. The mixture was allowed to react for three hours at room temperature. The formed white crystals were filtered off, washed with cold acetonitrile and dried to produce the amic acid adduct. Amic acid was mixed with triethylamine in toluene and the mixture heated to 130°C for two hours. The water of reaction was collected in a Dean-Stark trap. The organic solvent was evaporated off and sufficient 2M HCL added to reach pH 2. Extraction with ethyl acetate and drying over MgSO₄ followed by evaporating the solvent gave 6-maleimidocaproic acid (MCA).

MCA (76.83 g, 0.3641 mol) and 100 mL water were combined in a one liter, four-necked, round bottom flask equipped with a mechanical mixer, thermometer and pH probe. The reaction was heated with mixing to 60°C, which resulted in phasing-out. NH₄OH (assay 28-30 %) was added to raise the pH from 2.53 to ~7.0. During the add, the reaction temperature remained at 60° to 70°C and the reaction became a homogeneous clear dark copper color. Upon cooling to 37°C, the reaction turned turbid and started oiling out. Water, 50 mL, was added, which cleared the opaque reaction slightly. Addition of NH₄OH was continued until the pH reached about 7.25, at which point the reaction was an opaque gold mixture. The reaction was cooled to a slurry in an ice bath.

Meanwhile, a solution of copper (II) nitrate hemipentahydrate (Aldrich, 223395, 98 %) (50.00 g, 0.2150 mol) in 50 mL of water was prepared. The salt readily dissolved to a clear dark blue solution. The copper (II) nitrate hemipentahydrate solution was added to the reaction slurry over 27 minutes while maintaining the reaction temperature </= 10°C. A noticeable exotherm was not observed. Water (200 mL) was then added to thin the thick turquoise reaction mixture. The ice bath was removed and the reaction was mixed over night.

After 14 hours, the reaction solids formed a dark turquoise amorphous lump in a clear blue liquid. The liquid was decanted off and the solids were washed three times with water. Following the water washes, 300 mL of acetone was added to the solids, which had the effect of breaking up the lump. The blue colored acetone was decanted off and the step was repeated with 500 mL of acetone. With this wash, the solids were dispersed enough to allow stirring of the mixture for 30 minutes. Light turquoise solids were then filtered from the mixture leaving a light blue filtrate. This acetone wash was repeated twice more. The final acetone wash was clear and colorless. The reaction product was a light turquoise powder, which was dried in a vacuum oven over night at 45°C.

EXAMPLE 2. PREPARATION OF MALEIMIDOPROPIONIC ACID (2.1 MOL)/COPPER (II) NITRATE HEMIPENTAHYDRATE (1.0 MOL)

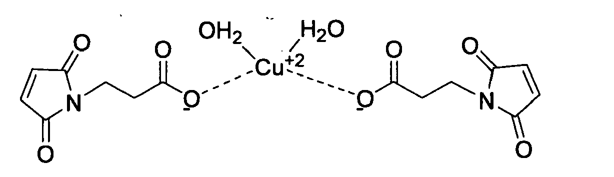

Maleimidopropionic acid (61.58 g, 0.3641 mol) and 100 mL water were combined in a 1 liter, four-necked, round bottom flask equipped with a mechanical mixer, thermometer and pH probe. The reaction was heated with mixing to 60°C, which resulted in a slightly hazy gold solution. While the reaction solution cooled to room temperature, a solution of copper (II) nitrate hemipentahydrate (Aldrich, 223395, 98 %) (50.00 g, 0.2150 mol in 50 mL of water) was prepared.

NH₄OH (assay 28-30 %) was added to raise the pH from 2.31 to ~7.0. During the add, the reaction temperature rose to 44°C and the reaction became a fairly clear orange-red color. Upon cooling to 25°C, the pH measured 6.64. At this temperature, the reaction became turbid and pink solids precipitated from the solution. Water, 50 mL, was added, and the addition of NH₄OH was continuted to raise the pH to about 7.32. The reaction was cooled in an ice bath to a slurry. The copper (II) nitrate hemipentahydrate solution was added to the reaction slurry over five minutes while maintaining the reaction temperature to 10°C or less. A noticeable exotherm was not observed. The reaction was mixed for two hours while cooling. The ice bath was then removed and the resultant fine dark turquoise mixture was mixed over night.

After 14 hours, the reaction was a turquoise mix of moderate viscosity. The blue-green reaction liquor was filtered off and the sky blue solids were mixed with 300 mL of water for 30 minutes and then filtered. This water wash was repeated twice more. Following the water washes, 300 mL of acetone was added to the solids. The mixture was stirred for 30 minutes and then filtered. This acetone wash was repeated twice more. The final acetone wash was clear and colorless. The reaction product was a light green-blue powder which was dried in a vacuum oven over two nights at 45°C. A yield of 28 grams was obtained from this reaction.

## Claims

1. A conductive composition comprising a resin, a conductive filler, and a metal salt of a maleimide acid.

2. The conductive composition according to claim 1 in which the metal salt of a maleimide is formed by
(i) reacting a molar equivalent of maleic anhydride with a molar equivalent of an amino acid to form an amic acid,
(ii) dehydrating the amic acid to form a maleimide acid, and
(iii) converting the maleimide acid to its metal salt.

3. The conductive resin composition according to claim 2 in which the amino acid is selected from the group consisting of glycine, alanine, 2-aminoisobutyric acid, valine, tert-leucine, norvaline, 2-amino-4-pentenoic acid, isoleucine, leucine, norleucine, beta-alanine, 5-aminovaleric acid, 6-aminocaproic acid, 7-aminoheptanoic acid, 8-aminocaprylic acid, 11-amino-undecanoic acid, 12-aminododecanoic acid, 2-phenylglycine, 2,2'-diphenylglycine, phenylalanine, alpha-methyl-DL-phenylalanine, and homophenylalanine.

4. The conductive composition according to claim 2 in which the metal salt of a maleimide is derived from the salts of the metal elements selected from the group consisting of lithium (Li), sodium (Na), magnesium (Mg), potassium (K), calcium (Ca), scandium (Sc), titanium (Ti), vanadium (V), chromium (Cr), manganese (Mn), iron (Fe), cobalt (Co), nickel (Ni), copper (Cu), zinc (Zn), palladium (Pd), platinum (Pt), silver (Ag), gold (Au), mercury (Hg), aluminum (Al), and tin (Sn).

5. The conductive composition according to claim 1 in which the maleimide metal salt will be present in the resin composition at a loading of 0.05% to 10% by weight of the composition.

6. The conductive composition according to claim 1 in which the resin is selected from the group consisting of phenolics, epoxies, acrylates, maleimides, polyimides, polyurethanes, vinyl chlorides, vinyl acetates, polyesters, silicones, benzoxazines, oxetane, thio-ene, oxazolines, nitrones, vinyl ethers, styrenics, and cinnamics.
